# EUROPEAN PATENT SPECIFICATION

(11) **EP 4 358 140 B1**
(45) Date of publication and mention of the grant of the patent: **11.03.2026**
(21) Application number: 22946064.7
(22) Date of filing: 09.10.2022
(51) Int. Cl.: H10B 12/00, H10D 84/00, H10D 84/80, H10D 62/10

(54) **MANUFACTURING METHOD FOR SEMICONDUCTOR STRUCTURE, AND SEMICONDUCTOR STRUCTURE**
HERSTELLUNGSVERFAHREN FÜR EINE HALBLEITERSTRUKTUR UND HALBLEITERSTRUKTUR
PROCÉDÉ DE FABRICATION POUR STRUCTURE SEMI-CONDUCTRICE, ET STRUCTURE SEMI-CONDUCTRICE

(30) Priority: 29.08.2022 CN 202211042659
(43) Date of publication of application: 24.04.2024
(73) Proprietor: Changxin Memory Technologies, Inc., Hefei, Anhui 230601 (CN)
(72) Inventor: TANG, Yi, Anhui 230601 (CN)
(74) Representative: Lavoix
(86) International application number: PCT/CN2022/124149
(87) International publication number: WO 2024/045265

(56) References cited:
- CN-A- 112 992 904
- CN-A- 113 745 224
- CN-A- 114 023 703
- CN-A- 114 023 703
- CN-A- 114 864 503
- CN-A- 114 864 503
- CN-A- 114 914 202
- CN-A- 114 927 477
- US-A1- 2019 296 155
- US-A1- 2022 254 784
- US-A1- 2023 380 140
- US-B2- 11 410 951

## Description

### CROSS-REFERENCE TO RELATED APPLICATION

This application claims the priority to Chinese Patent Application No. 202211042659.4, filed on August 29, 2022, and entitled "METHOD FOR MANUFACTURING SEMICONDUCTOR STRUCTURE AND SEMICONDUCTOR STRUCTURE'.

### TECHNICAL FIELD

Embodiments of the application relate to the field of semiconductors, and in particular to a method for manufacturing a semiconductor structure and a semiconductor structure.

### BACKGROUND

With the continuous development of a semiconductor structure, a critical dimension of the semiconductor structure is continuously reduced. However, due to the limitation of a lithography machine, there is a limit of a reduction of the critical dimension of the semiconductor structure. Therefore, how to make a chip with a higher storage density on a wafer is a research direction of many researchers and semiconductor practitioners. In a two-dimensional semiconductor device or a planar semiconductor device, memory cells are arranged in a horizontal direction. Therefore, a integration density of the two-dimensional semiconductor device or the planar semiconductor device may be determined by an area occupied by each memory cell, and the integration density of the two-dimensional semiconductor device or the planar semiconductor device is greatly affected by the technology of forming a fine pattern, so that there is a limit of the continuous increase of the integration density of the two-dimensional semiconductor device or the planar semiconductor device. Therefore, the two-dimensional semiconductor device is developing towards a three-dimensional semiconductor device.

However, in the three-dimensional semiconductor device, higher storage density, a faster speed and lower power consumption are still being pursued. Related technologies are discussed in US11410951B2, CN114023703A and US20220068350A1.

### SUMMARY

Embodiments of the application provide a method for manufacturing a semiconductor structure, which may at least improve the mobility of carriers of the semiconductor structure.

The invention is set out in the appended set of claims.

The technical solution according to the embodiments of the application has at least the following advantages. A plurality of stack structures and a plurality of first isolation layers are formed on a surface of a base, the plurality of stack structures are spaced apart from each other along a first direction, and the plurality of first isolation layers are arranged between the plurality of stack structures adjacent to each other. A plurality of initial active layers of the plurality of stack structures are etched to form a plurality of first trenches. A plurality of oxide semiconductor layers are formed in the plurality of first trenches, and portions of the plurality of oxide semiconductor layers and remaining portions of the plurality of initial active layers are etched to form a plurality of active structures arranged in an array along the first direction and a second direction. In this way, the formation of the plurality of oxide semiconductor layers may improve the mobility of carriers of the plurality of active structures.

### BRIEF DESCRIPTION OF THE DRAWINGS

One or more embodiments are exemplarily illustrated by the figures in the drawings corresponding to each of the embodiments, and these exemplary illustrations do not constitute a limitation of the embodiments. The figures in the drawings do not constitute a limitation of a scale unless otherwise stated. In order to more clearly illustrate the technical solution in the embodiments of the application or in the related art, the drawings used in the embodiments will be briefly described below. It will be apparent that the drawings described below are only some embodiments of the application, and for those skilled in the art, other drawings may be obtained according to these drawings without creative labor.
FIG. 1 to FIG. 21 are schematic diagrams corresponding to operations of a method for manufacturing a semiconductor structure according to an embodiment of the application;
FIG. 22 is a schematic diagram of a semiconductor structure according to an embodiment of the application.

### DETAILED DESCRIPTION

An embodiment of the application provides a method for manufacturing a semiconductor structure. After a plurality of stack structures are formed on a surface of a base, a plurality of initial active layers of the plurality of stack structures are etched to form a plurality of first trenches, and a plurality of oxide semiconductor layers are formed in the plurality of first trenches. Portions of the plurality of oxide semiconductor layers and remaining portions of the plurality of initial active layers are etched to form the plurality of active structures arranged in an array along a first direction and a second direction. Portion of each the initial active layer is etched without considering the doping and stress problems encountered during a stacking process. Subsequently, the fact that each of the plurality of oxide semiconductor layers is formed as a portion of a respective one of the plurality of active structures and the plurality of active structures are formed may improve the mobility of carriers of the semiconductor structure.

Embodiments of the application will be described in detail below in combination with the drawings. However, those skilled in the art will appreciate that many technical details are presented in the various embodiments of the application, in order to enable the reader to better understand the embodiments of the application. However, even without these technical details and various variations and modifications based on the following various embodiments, the technical solutions claimed by the embodiments of the application may be realized.

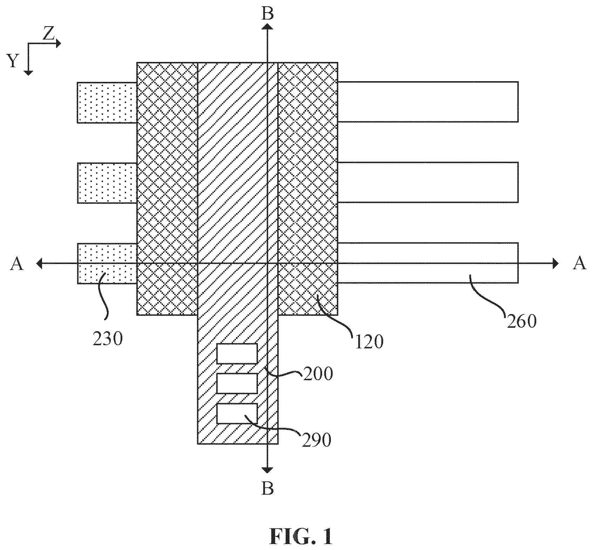

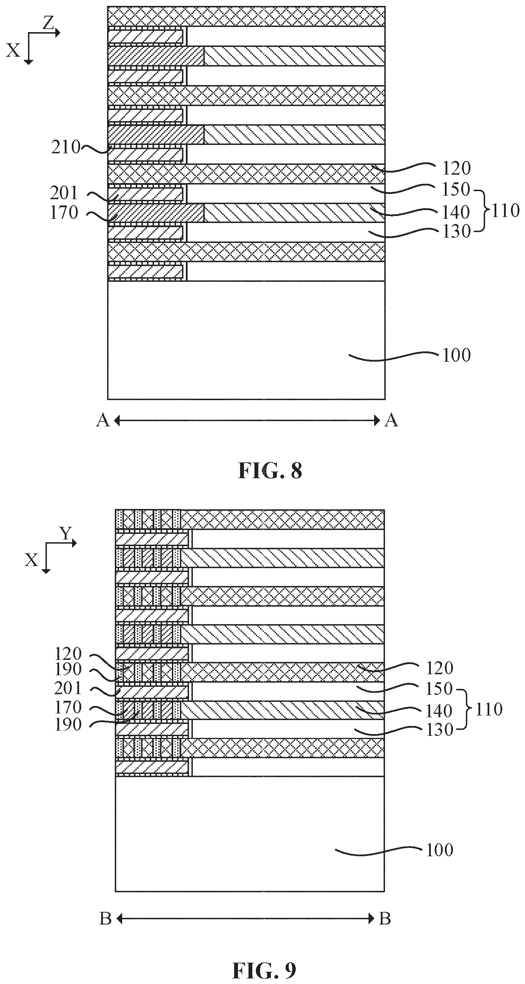

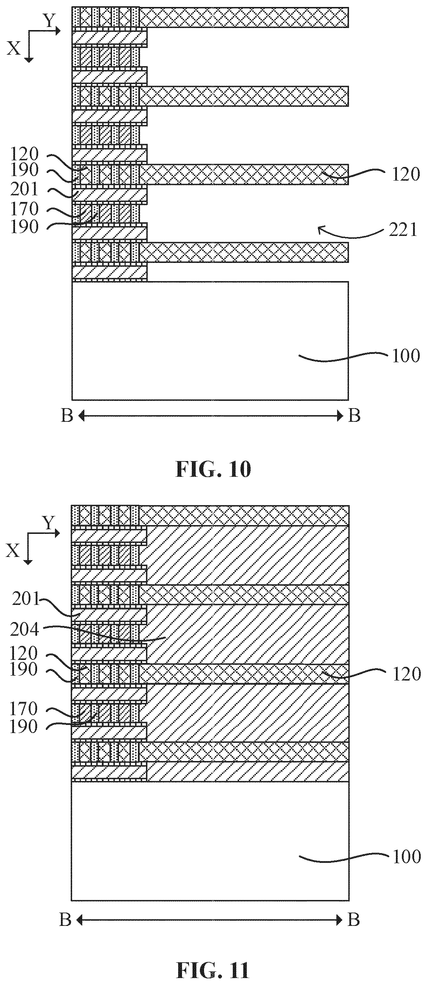

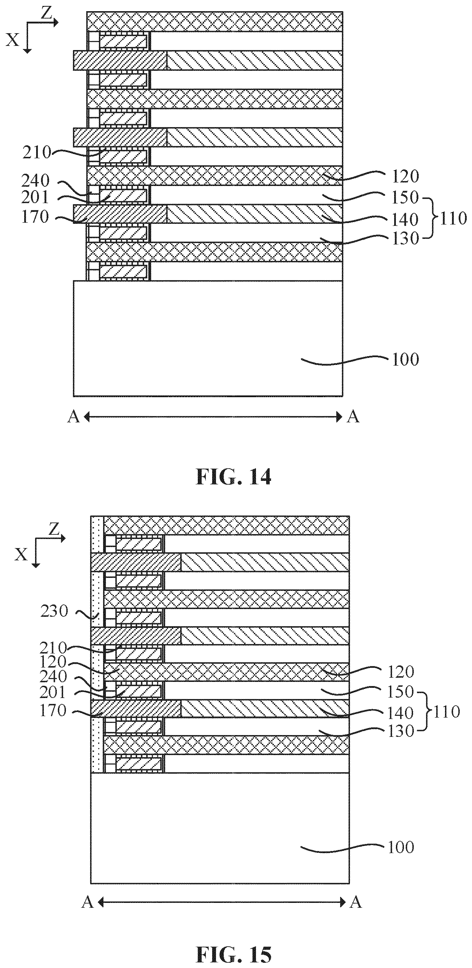

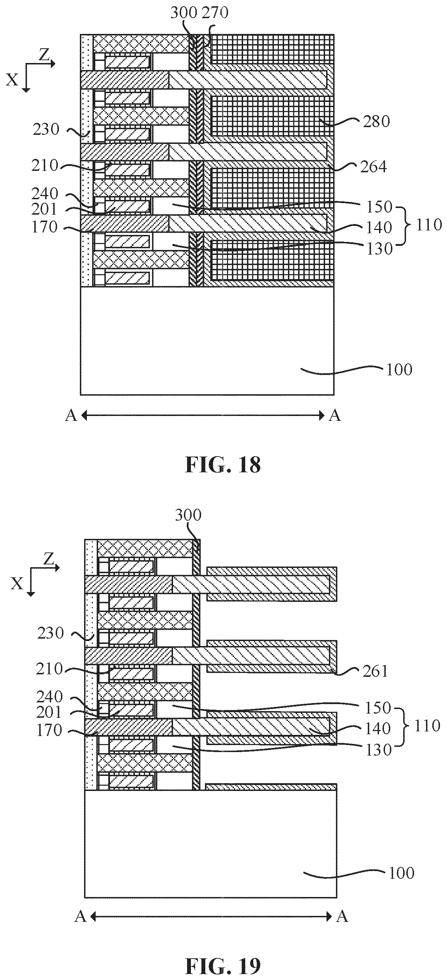

Referring to FIG. 1 to FIG. 21, FIG. 1 to FIG. 21 are schematic diagrams corresponding to operations of a method for manufacturing a semiconductor structure according to an embodiment of the application.

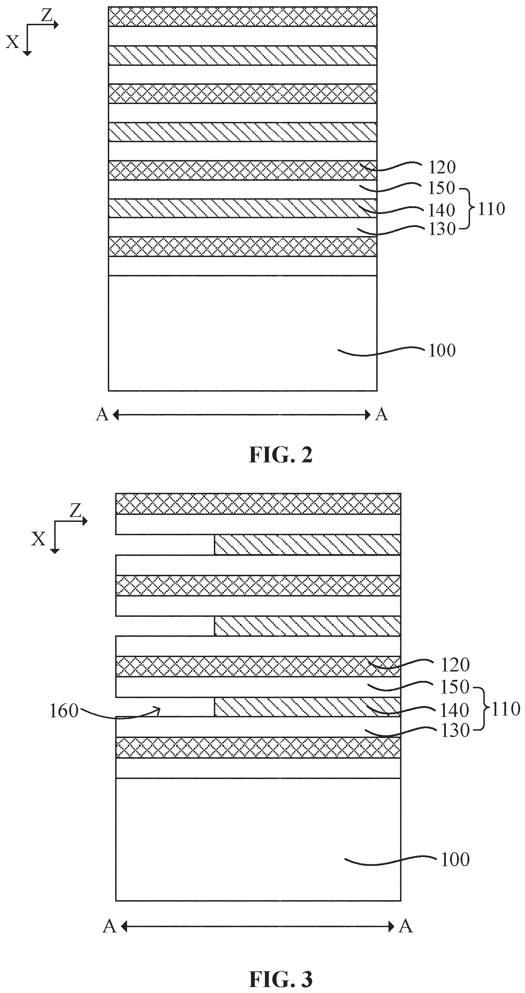

Specifically, referring to FIG. 1 and FIG. 2, FIG. 1 is a top view of the semiconductor structure, and FIG. 2 is a cross-sectional view taken along an AA direction of FIG. 1.

Specifically, a base 100 is provided. A plurality of stack structures 110 are formed on a surface of the base 100 and a plurality of first isolation layers 120 are formed, the plurality of stack structures 110 are spaced apart from each other along a first direction X, and the plurality of first isolation layers 120 are arranged between the plurality of stack structures 110 adjacent to each other. Each of the plurality of stack structures 110 includes a first interlayer dielectric layer 130, an initial active layer 140 and a second interlayer dielectric layer 150.

In some embodiments, the base 100 is a semiconductor material, and the semiconductor material includes but is not limited to any one of a silicon substrate, a germanium substrate, a germanium-silicon substrate or a silicon carbide substrate. The base 100 may also be a substrate doped with ions, and the doped ions are N-type ions or P-type ions. Specifically, the N-type ions may be phosphorus ions, arsenic ions or antimony ions, and the P-type ions may be boron ions, indium ions or boron fluoride ions.

In some examples, the material of the first interlayer dielectric layer 130 may be the same as the material of the second interlayer dielectric layer 150, and the material of the first interlayer dielectric layer 130 and the material of the second interlayer dielectric layer 150 may be an insulating material such as silicon oxide. The formation of the first interlayer dielectric layer 130 and the second interlayer dielectric layer 150 may provide a basis for the subsequent formation of a plurality of bit lines. Every two adjacent initial active layers 140 of a plurality of initial active layers 140 spaced apart from each other along the first direction X may also be isolated from each other by a respective one of a plurality of first interlayer dielectric layers 130 and a respective one of a plurality of second interlayer dielectric layers 150.

The material of the plurality of initial active layers 140 may be a semiconductor material such as silicon and polysilicon. The formation of the plurality of initial active layers 140 may provide a process basis for the subsequent formation of a plurality of active structures arranged in an array.

In some embodiments, the plurality of initial active layers 140 are also doped with ions. The doped ions may be selected as N-type ions or P-type the ions as required, and the concentration of the doped ions may range from 1E19 cm⁻³ to 1E22 cm⁻³.

Referring to FIG. 3, portion of each initial active layer 140 is etched to form a first trench 160 in each initial active layer 140. The formation of each of a plurality of first trenches 160 may provide a process basis for the subsequent formation of a respective one of a plurality of oxide semiconductor layers.

In some embodiments, the method of etching the portion of each initial active layer 140 may be achieved by etching each initial active layer 140 through a side wall of a respective one of the plurality of stack structures 110 by means of a wet etching.

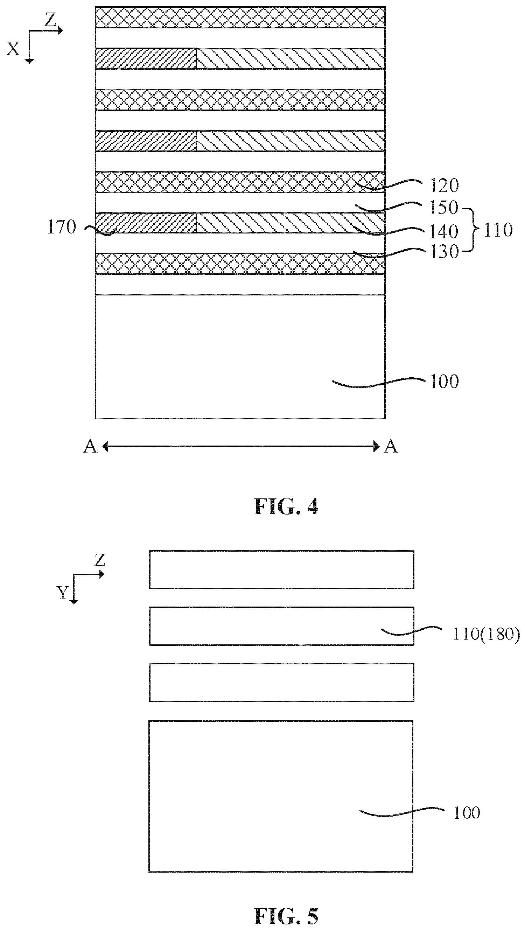

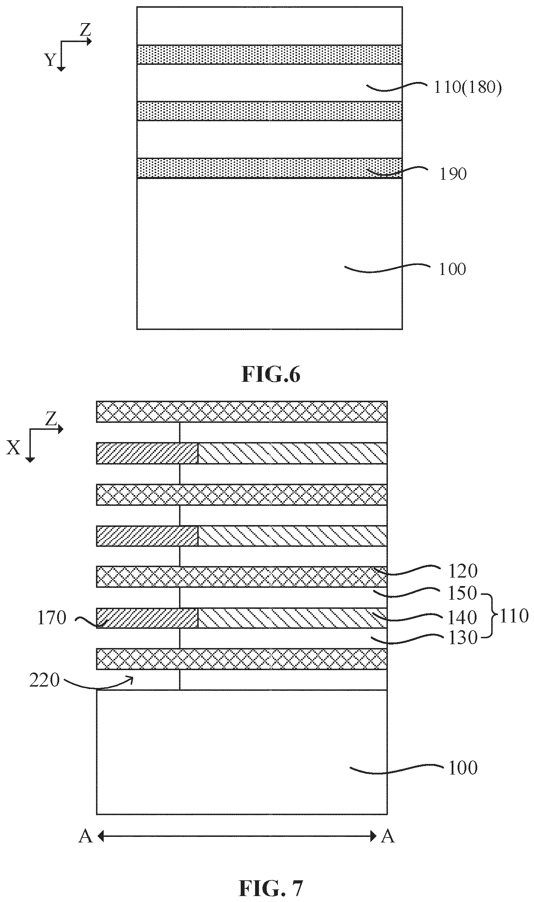

Referring to FIG. 4 to FIG. 6, FIG. 4 is a cross-sectional view taken along an AA direction of FIG. 1, and each of FIG. 5 and FIG. 6 is a top view of the semiconductor structure.

A plurality of oxide semiconductor layers 170 are formed in a plurality of first trenches 160, and each of the plurality of oxide semiconductor layers 170 is in contact with a remaining portion of a respective one of the plurality of initial active layers 140. Portions of the plurality of oxide semiconductor layers 170 and the remaining portions of the plurality of initial active layers 140 are etched to form a plurality of active structures 180 arranged in an array along the first direction X and a second direction Y. The first direction X is perpendicular to a surface of the base 100, and the second direction Y is parallel to the surface of the base 100.

In some embodiments, each of the plurality of oxide semiconductor layers 170 may be formed by means of an atomic layer deposition, to fill the plurality of first trenches 160 formed by etching the plurality of initial active layers 140.

In some embodiments, a material of the plurality of oxide semiconductor layers 170 may include indium gallium zinc oxide or zinc tin oxide. The fact that the material of the plurality of oxide semiconductor layers is set as indium gallium zinc oxide or zinc tin oxide may improve the mobility of ions of the plurality of oxide semiconductor layers 170, and may improve the performance of the plurality of oxide semiconductor layers 170 serving as a plurality of channel regions. The material of the plurality of oxide semiconductor layers 170 may also be one or more of indium zinc oxide, indium gallium silicon oxide, indium tungsten oxide, indium oxide, tin oxide, titanium oxide, magnesium zinc oxide, zirconium indium zinc oxide, hafnium indium zinc oxide, tin indium zinc oxide, aluminum tin indium zinc oxide, silicon indium zinc oxide, aluminum zinc tin oxide, gallium zinc tin oxide, zirconium zinc tin oxide or other similar materials.

In some embodiments, the operation that the portion of each of the plurality of oxide semiconductor layers 170 is etched includes the following operations. The plurality of stack structures 110 are etched to form the plurality of active structures 180 spaced apart from each other along the second direction Y. A plurality of second isolation layers 190 are formed, and the plurality of second isolation layers 190 are arranged between the plurality of active structures 180 spaced apart from each other along the second direction Y. The plurality of oxide semiconductor layers 170 and the plurality of stack structures are etched to form the plurality of oxide semiconductor layers 170 spaced apart from each other along the first direction and the plurality of initial active layers 140 spaced apart from each other along the first direction. Remaining portions of the plurality of oxide semiconductor layers 170 and remaining portions of the plurality of initial active layers 140 form the plurality of active structures 180. Every two adjacent active structures 180 of the plurality of active structures 180 arranged along the second direction Y may be isolated from each other by a respective one of the plurality of second isolation layers 190, which may prevent the mutual influence of the plurality of active structures 180 arranged along the second direction Y.

Referring to FIG. 7 to FIG. 12, in some embodiments, after the plurality of active structures 180 are formed, the method further includes the following operations. A plurality of word lines 200 are formed. Each of the plurality of word lines 200 surrounds a part of a surface of a respective one of the plurality of oxide semiconductor layers 170, and each of the plurality of word lines 200 extends along one of the first direction X and the second direction Y. The formation of the plurality of word lines 200 may control the conduction of the plurality of active structures 180, that is, the plurality of word lines 200 may serve as a gate to control the flow of the carriers of the plurality of active structures 180. The formation of each of the plurality of word lines 200 surrounding a respective one of the plurality of oxide semiconductor layers 170 may improve the control ability of the plurality of word lines 200.

In some embodiments, taking each of the plurality of word lines 200 extending along the second direction Y as an example, each word line 200 covers a top surface of each of multiple active structures 180 arranged along the second direction Y. That is, one word line 200 may control the conduction of the multiple active structures 180, which may improve a stacking density of the semiconductor structure, and which may improve a utilization rate of a space of the semiconductor structure.

In some embodiments, each of the plurality of word lines 200 extends along the second direction Y, and the method that the plurality of word lines 200 are formed includes the following operations. A plurality of first word lines 201 are formed, and each of the plurality of first word lines 201 surround a respective one of the plurality of oxide semiconductor layers 170. A plurality of second word lines 203 are formed, and each of the plurality of second word lines 203 covers a side wall of a respective one of the plurality of first word lines 201. Each of the plurality of first word line 201 surrounding the surface of a respective one of the plurality of oxide semiconductor layers 170 may improve a contact area between each of the plurality of word lines 200 and a respective one of the plurality of active structures 180, and the formation of each of the plurality of second word lines 203 may also provide a conduction basis for the subsequent formation of each of a plurality of conductive pillars connected with a respective one of the plurality of word lines 200.

In some embodiments, the material of the plurality of first word lines 201 may be the same as the material of the plurality of second word lines 203, and the material of the plurality of first word lines 201 and the material of the plurality of second word lines 203 may be, for example, a conductive material such as titanium, titanium nitride, tungsten, aluminum and cobalt. In other examples, the material of the plurality of first word lines 201 and the material of the plurality of second word lines 203 may also be different and may be adjusted according to the actual situations.

In some embodiments, the method that the plurality of first word lines 201 are formed may include the following operations. The plurality of first interlayer dielectric layers 130 and the plurality of second interlayer dielectric layers 150 of the plurality of stack structures 110 are etched to form a plurality of first grooves 220. A plurality of gate dielectric layers 210 are formed on surfaces of the plurality of first grooves 220. The plurality of first word lines 201 are formed on surfaces of the plurality of gate dielectric layers 210, and the plurality of first grooves 220 are fully filled with the plurality of gate dielectric layers 210 and the plurality of first word lines 201. It can be understood that the operation the plurality of first interlayer dielectric layers 130 and the plurality of second interlayer dielectric layers 150 of the plurality of stack structures 110 are etched further includes the following operations. Portions of the plurality of second isolation layers 190 are etched, to allow each first groove 220 exposing a surface of a respective one of the plurality of oxide semiconductor layers 170 of the plurality of active structures 180 to be formed. The formation of the plurality of first word lines 201 may improve an area of each of the plurality of word lines 200 directly facing a respective one of the plurality of active structures 180 and may improve the ability of the plurality of word lines 200 to control the conduction of the plurality of active structures 180.

It can be understood that when the plurality of word lines 200 provide a voltage to control the conduction of the plurality of active structures 180, the carriers of the plurality of active structures 180 flow toward the plurality of word lines 200. However, the carriers may not flow into the plurality of word lines 200 due to the presence of the plurality of gate dielectric layers 210, therefore the carriers converge on a surface of each of the plurality of gate dielectric layers 210 close to a respective one of the plurality of active structures 180 to form the current.

In some embodiments, the material of the plurality of gate dielectric layers 210 may be an insulating material such as silicon oxide, silicon nitride and hafnium oxide, and the material of the plurality of gate dielectric layers 210 may be selected according to a dielectric constant required by the plurality of gate dielectric layers 210.

In some embodiments, a thickness of each of the plurality of gate dielectric layers 210 may range from 8 nm to 20 nm. It can be understood that in a case that other conditions are equal, the thinner the thickness of each of the plurality of gate dielectric layers 210 is, the better the performance of the semiconductor structure is, but the lower the reliability of the semiconductor structure is, and more likely the current tunneling effect is to occur. Conversely, the thicker the thickness of each of the plurality of gate dielectric layers 210 is, the higher the reliability of the semiconductor structure is, but the performance of the semiconductor structure may be degraded. The fact that the thickness of each of the plurality of gate dielectric layers 210 is set to range from 8 nm to 20 nm may improve the performance of the semiconductor structure while ensuring the certain reliability thereof.

The formation of the plurality of gate dielectric layers 210 and the plurality of first isolation layers 120 may also facilitate isolation of the plurality of oxide semiconductor layers 170 of the plurality of active structures 180 from oxygen and water vapor in the air, to improve the reliability of the semiconductor structure.

In some embodiments, the method that the plurality of second word lines 203 are formed includes the following operations. The plurality of stack structures 110 are etched along the second direction Y to form a plurality of second grooves 221, and each second groove 221 exposes a side wall of a respective one of the plurality of first word lines 201. A plurality of second initial word lines 204 are formed, and the plurality of second grooves 221 are fully filled with the plurality of second initial word lines 204. The plurality of second initial word lines 204 are etched to form the plurality of second word lines 203. The plurality of second word lines 203 are arranged along the first direction X and lengths of the plurality of second word lines 203 in the second direction Y sequentially decrease. The plurality of second word lines 203 with sequentially decreased lengths in the second direction Y may cooperate with a plurality of conductive pillars that is subsequently formed to conduct with the plurality of word lines 200, to form a one-one correspondence connection between the plurality of word lines 200 and the plurality of conductive pillars. The plurality of conductive pillars lead out different word lines 200, to control each of the plurality of word lines 200 corresponding to a respective one of the plurality of conductive pillars by different conductive pillars, and to control the supply of an electrical signal to any one of the plurality of word lines 200.

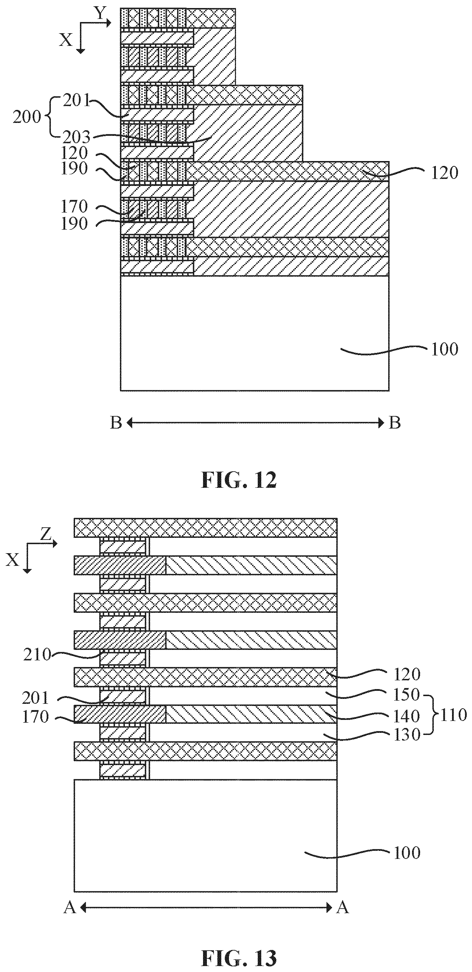

Referring to FIG. 13 to FIG. 15, in some embodiments, the method further includes the following operations. A plurality of bit lines 230 are formed. Each of the plurality of bit lines 230 surrounds a part of a surface of a respective one of the plurality of oxide semiconductor layers 170, each of the plurality of bit lines 230 is spaced from a respective one of the plurality of word lines 200, and each of the plurality of bit lines 230 extends along another one of the first direction X and the second direction Y. It can be understood that an extending direction of each of the plurality of word lines 200 intersects with an extending direction of a respective one of the plurality of bit lines 230. Each of the plurality of word lines 200 extends along the first direction X, and each of the plurality of bit lines 230 extends along the second direction Y. Each of the plurality of word lines 200 extends along the second direction Y, and each of the plurality of bit lines 230 extends along the first direction X.

In some embodiments, taking each of the plurality of bit lines 230 extending along the first direction as an example, each bit line 230 may be in contact with each of multiple active structures 180 arranged along the first direction. That is, one bit line 230 may transmit a signal to each of the multiple active structures 180 arranged along the first direction, which may improve the stacking density of the semiconductor structure, and which may improve the utilization rate of the space of the semiconductor structure.

However, it can be understood that the extending direction of each of the plurality of word lines 200 intersects with the extending direction of each of the plurality of bit lines 230, and there is only one intersection point between one bit line 230 and one word line 200. That is, one active structure 180 may be selected by means of one word line 200 and one bit line 230.

In some embodiments, the method that the plurality of bit lines 230 are formed may include the following operations. A plurality of third isolation layers 240 are formed. Each of the plurality of third isolation layers 240 covers a part of a surface of a respective one of the plurality of oxide semiconductor layers 170, and each of the plurality of third isolation layers 240 is in contact with a side wall arranged along a third direction Z of a respective one of the plurality of word lines 200. The plurality of bit lines 230 are formed. Each of the plurality of bit lines 230 is in contact with a side wall arranged along the third direction of a respective one of the plurality of third isolation layers 240, and each of the plurality of the bit lines 230 covers a respective one of the plurality of oxide semiconductor layers 170. The plurality of third isolation layers 240 may isolate the plurality of bit lines 230 from the plurality of word lines 200, which may prevent an electrical connection between the plurality of bit lines 230 and the plurality of word lines 200, and which may improve the reliability of the semiconductor structure. The formation of the plurality of bit lines 230 provides a basis for the reading out data and the writing data of the semiconductor structure.

In some embodiments, the method that the plurality of third isolation layers 240 are formed may include the following operations. A portion of each of the plurality of first word lines is etched to expose a part of a surface of a respective one of the plurality of oxide semiconductor layers 170, where a portion of each of the plurality of gate dielectric layers 210 is etched while the plurality of first word lines 201 is etched. A plurality of third initial isolation layers 241 are formed, and each of the plurality of third initial isolation layers 241 is arranged between a respective one of the plurality of first isolation layers 120 and a respective one of the plurality of oxide semiconductor layers 170. Each of the plurality of third initial isolation layers 241 is etched, where remaining portions of the plurality of third initial isolation layers 241 serve as the plurality of third isolation layers 240.

In some embodiments, the method further includes the following operation. The plurality of first isolation layers 120 are etched when the plurality of third initial isolation layers 241 are etched. In the process of forming the plurality of bit lines 230, each of the plurality of formed bit lines 230 may also cover a side wall of a respective one of the plurality of first isolation layers 120.

In some embodiments, the material of the plurality of third initial isolation layers 241 may be the same as the material of the plurality of first isolation layers 120, and the material of the plurality of third initial isolation layers 241 and the material of the plurality of first isolation layers 120 may be silicon nitride. The plurality of third initial isolation layers 241 and the plurality of first isolation layers may be etched by means of the same etching agent, to reduce the types of etching agents and the process operations.

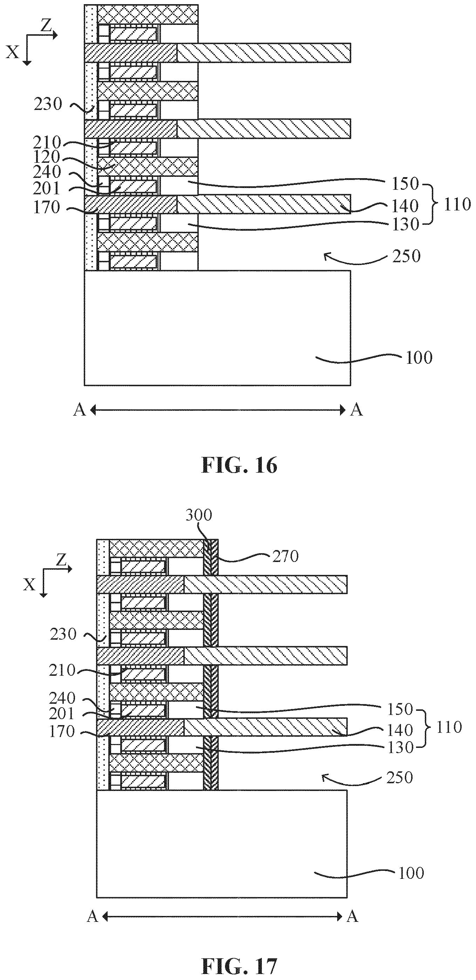

Referring to FIG. 16 to FIG. 21, in some embodiments, the method further includes the following operations. The plurality of first interlayer dielectric layers 130, the plurality of first isolation layers 120 and the plurality of second interlayer dielectric layers 150 are etched to form a plurality of third grooves 250, and each of the plurality of third grooves 250 exposes a part of a surface of the remaining portion of a respective one of the plurality of initial active layers 140. A plurality of lower electrode plates 261 are formed, and each of the plurality of lower electrode plates 261 covers a part of the surface of the remaining portion of a respective one of the plurality of initial active layers 140. A plurality of capacitive dielectric layers 262 are formed, and each of the plurality of capacitive dielectric layers 262 covers a surface of a respective one of the plurality of lower electrode plates 261 and another part of the surface of the remaining portion of a respective one of the plurality of initial active layers 140. A plurality of upper electrode plates 263 are formed, and the plurality of upper electrode plates 263 cover surfaces of the plurality of capacitive dielectric layers 262. The plurality of lower electrode plates 261, the plurality of capacitive dielectric layers 262 and the plurality of upper electrode plates 263 form a plurality of capacitors 260.

The material of the plurality of lower electrode plates 261 may include any one or any combination of metal materials such as titanium nitride, tantalum nitride, copper and tungsten. The material of the plurality of capacitive dielectric layers 262 may include any one or any combination of ZrO, AlO, ZrNbO, ZrHfO or ZrAlO. The material of the plurality of upper electrode plates 263 includes compounds formed of one or two of metal nitride or metal silicide, such as titanium nitride, titanium silicide, nickel silicide, titanium silicon nitride and other conductive materials, or the material of the plurality of upper electrode plates 263 may be conductive semiconductor materials such as polysilicon and germanium silicon.

It can be understood that a relative area of each of the plurality of lower electrode plates 261 and a respective one of the plurality of upper electrode plates 263 of the plurality of capacitors 260, a distance between each of the plurality of lower electrode plates 261 and a respective one of the plurality of upper electrode plates 263, and the material of the plurality of capacitive dielectric layers 262 may affect the capacity of the plurality of capacitors 260. Therefore, the relative area of each of the plurality of lower electrode plates 261 and a respective one of the plurality of upper electrode plates 263 of the plurality of capacitors 260, the distance between each of the plurality of lower electrode plates 261 and the respective one of the plurality of upper electrode plates 263, and the material of the plurality of capacitive dielectric layers 262 may be provided according to the actual requirements.

In some embodiments, multiple capacitors 260 of the plurality of capacitors 260 arranged along the first direction share one upper electrode plate 263. The formation of the multiple capacitors 260 of the plurality of capacitors 260 sharing one upper electrode plate 263 may improve the utilization rate of the space of the semiconductor structure and may facilitate the formation of the semiconductor structure.

In some embodiments, referring to FIG. 17 to FIG. 19, the operation that the plurality of lower electrode plates 261 are formed includes the following operations. A plurality of fourth isolation layers 270 are formed, and each of the plurality of fourth isolation layers 270 covers a surface of a side wall arranged along the third direction Z of a respective one of the plurality of third grooves 250. A plurality of initial lower electrode plates 264 are formed, and each of the plurality of initial lower electrode plates 264 covers a surface of a respective one of the plurality of fourth isolation layers 270 and the surface of the remaining portion of a respective one of the plurality of initial active layers 140. The plurality of fourth isolation layers 270, and portions of the plurality of initial lower electrode plates 264 that cover surfaces of the plurality of fourth isolation layers 270 are removed, where remaining portions of the plurality of initial lower electrodes plates 264 serve as the plurality of lower electrode plates 261. The formation of the plurality of fourth isolation layers provides a process basis for the subsequent formation of the plurality of lower electrode plates 261 spaced from each other, thus different capacitors 260 may be respectively defined by the plurality of lower electrode plates 261 spaced from each other.

In some embodiments, before the plurality of fourth isolation layers 270 are formed, the method further includes the following operations. A plurality of sixth isolation layers 300 are formed, and each of the plurality of sixth isolation layers 300 is arranged between a respective one of the plurality of fourth isolation layers 270 and a remaining portion of a respective one of the plurality of stack structures 110. The formation of the plurality of sixth isolation layers 300 may improve the insulation between the plurality of capacitors 260 and the plurality of word lines 200.

In some embodiments, the operation that the plurality of fourth isolation layers 270, and portions of the plurality of initial lower electrode plates 264 that cover surfaces of the plurality of fourth isolation layers 270 are removed may include the following operations. A plurality of fifth isolation layers 280 are formed, and the plurality of fifth isolation layers 280 cover surfaces of the plurality of initial lower electrode plates 264 arranged on surfaces of the plurality of initial active layers 140. The plurality of fifth isolation layers 280 may cover portions of the plurality of initial lower electrode plates 264 that do not need to be etched, and then portions of the plurality of initial lower electrode plates 264 that do not need to be etched and the plurality of fourth isolation layers 270 are etched, which may improve the pattern accuracy of the plurality of formed lower electrode plates 261, and which may also protect the plurality of formed lower electrode plates 261 during the etching of the plurality of initial lower electrode plates 264 and the plurality of fourth isolation layers 270.

In some embodiments, the material of the plurality of fourth isolation layers 270 may be silicon oxide, the material of the plurality of fifth isolation layers 280 may be silicon oxynitride, and the material of the plurality of sixth isolation layers 300 may be silicon nitride. The material of the plurality of fourth isolation layers 270 and the material of the plurality of fifth isolation layers 280 are softer, to facilitate the subsequent etching process. The material of the plurality of sixth isolation layers 300 is harder, to facilitate the subsequent formation of the plurality of capacitive dielectric layers 262 and the plurality of upper electrode plates 263 attached to surfaces of the plurality of sixth isolation layers 300.

In some embodiments, after the plurality of lower electrode plates 261 are formed, the method may further include the following operation. The plurality of fifth isolation layers 280 are removed, to provide a process basis for the subsequent formation of the plurality of capacitive dielectric layers 262 and the plurality of upper electrode plates 263.

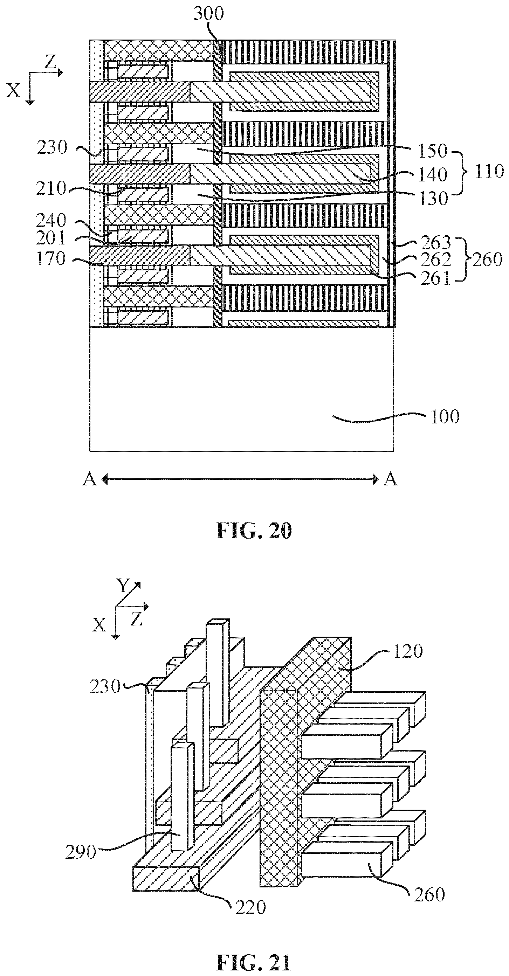

In some embodiments, referring to FIG. 21, a plurality of conductive pillars 290 is formed. Each of the plurality of conductive pillars 290 is in contact with a respective one of the plurality of second word lines 203, and each of the plurality of conductive pillars 290 is arranged in one-to-one correspondence with the respective one of the plurality of second word lines 203. In this way, an electrical signal is supplied to each of the plurality of word lines 200 corresponding to a respective one of the plurality of conductive pillars 290 by the supply of the signal to different conductive pillars 290, that is, different word lines 200 may be controlled by the controlling of the different conductive pillars 290.

In the embodiment of the application, a plurality of stack structures 110 and a plurality of first isolation layers 120 are formed on a base 100, the plurality of stack structures are spaced apart from each other along a first direction X, and the plurality of first isolation layers 120 are arranged between the plurality of stack structures 110.A plurality of initial active layers 140 are etched to form a plurality of first trenches 160. A plurality of oxide semiconductor layers 170 are formed in the plurality of first trenches 160. The plurality of oxide semiconductor layers 170 are in contact with remaining portions of the plurality of initial active layers 140, to form a plurality of active structures 180. In this way, the mobility of carriers of the plurality of active structures 180 may be improved, and a transmission rate of a semiconductor structure may be improved.

Another embodiment of the application also provides a semiconductor structure, which may be formed by part or all of the operations of the method for manufacturing the semiconductor structure. The parts corresponding to or identical to the parts of the above embodiments will not be repeated herein. The semiconductor structure according to another embodiment of the application will be described below with reference to the drawings.

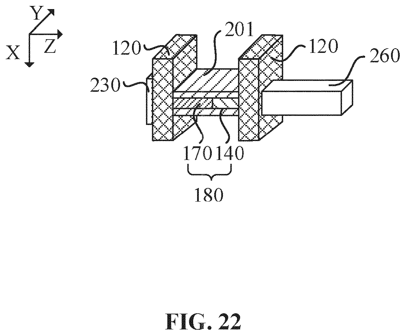

Referring to FIG. 12, FIG. 20, FIG. 21 and FIG. 22, the semiconductor structure may include a base 100, a plurality of active structures 180, and a plurality of first isolation layers 120. The plurality of active structures 180 are arranged on a surface of the base 100 and spaced from each other along a first direction X and a second direction Y. The plurality of active structures 180 include a plurality of oxide semiconductor layers 170 and a plurality of initial active layers 140 both arranged along a third direction Z, and each of the plurality of oxide semiconductor layers 170 is in contact with a respective one of the plurality of initial active layers 140. The first direction X is perpendicular to the surface of the base 100, and the second direction Y is parallel to the surface of the base 100. The plurality of first isolation layers 120 are arranged between the plurality of active structures 180 adjacent to each other in the first direction X, and a projection of each of the plurality of first isolation layers 120 on the surface of the base 100 overlap with a projection of a respective one of the plurality of active structures 180 on the surface of the base 100.

The fact that the plurality of active structures 180 include the plurality of oxide semiconductor layers 170 and the plurality of initial active layers 140 may improve the mobility of carriers of the plurality of active structures 180. The fact that the plurality of oxide semiconductor layers 170 serve as channel regions of the plurality of active structures 180 may improve the activity of carriers of the plurality of oxide semiconductor layers 170 and may improve the mobility of carriers of the plurality of oxide semiconductor layers 170. The fact that the plurality of first isolation layers 120 are arranged between the plurality of active structures 180 adjacent to each other in the first direction X may allow the plurality of active structures 180 to be spaced from each other in the first direction X and may prevent the mutual interference of the plurality of active structures 180.

In some embodiments, the semiconductor structure further includes a plurality of word lines 200, a plurality of bit lines 230 and a plurality of capacitors 260. Each of the plurality of word lines 200 surrounds a part of a surface of a respective one of the plurality of oxide semiconductor layers 170, and each of the plurality of word lines 200 extends along one of the first direction X and the second direction Y. Each of the plurality of bit lines 230 surrounds a part of the surface of a respective one of the plurality of oxide semiconductor layers 170, each of the plurality of bit lines 230 is spaced from a respective one of the plurality of word lines 200, and each of the plurality of bit lines 230 extends along another one of the first direction X and the second direction Y. Each of the plurality of capacitors 260 is in contact with a respective one of the plurality of initial active layers 140. The plurality of capacitors 260 extend along the first direction X, and are spaced apart from each other along the second direction Y and the third direction Z. The fact that each of the plurality of word lines 200 surrounds a part of the surface of a respective one of the plurality of oxide semiconductor layers 170 of the plurality of active structures 180 may control the conduction of the plurality of active structures 180. The fact that each of the plurality of bit lines 230 is in contact with a respective one of the plurality of oxide semiconductor layers 170, and the plurality of bit lines are formed may realize the reading out data and the writing data of the semiconductor structure. The fact that each of the plurality of capacitors 260 is in contact with a respective one of the plurality of initial active layers 140 may realize the storage of the semiconductor structure.

In some embodiments, each of the plurality of word lines 200 extends along the second direction Y, and the plurality of word lines 200 includes a plurality of first word lines 201 and a plurality of second word lines 203. Each of the plurality of first word lines 201 surrounds a part of the surface of a respective one of the plurality of oxide semiconductor layers 170. Each of the plurality of second word lines 203 covers a side wall of a respective one of the plurality of first word lines 201. The plurality of first word lines 201 may improve an area of each of the plurality of word lines 200 directly facing a respective one of the plurality of active structures 180 and may improve the ability of the plurality of word lines 200 to control the conduction of the plurality of active structures 180. The plurality of second word lines 203 may be intended to form a one-to-one correspondence connection with a plurality of conductive pillars 290.

In some embodiments, the plurality of second word lines 203 are arranged along the first direction X and lengths of the plurality of second word lines 203 in the second direction Y sequentially decrease. The plurality of second word lines 203 with sequentially decreased lengths may be led out by the plurality of conductive pillars 290, which may prevent the mutual interference between any adjacent conductive pillars 290 of the plurality of conductive pillars 290.

In some embodiments, a part of a projection of each of the plurality of second word lines 203 on the surface of the base 100 overlaps with a part of a projection of a respective one of the plurality of first word lines 201 on the surface of the base 100. That is, each of the plurality of second word lines 203 is in contact with a surface of a side wall of a respective one of the plurality of first word lines 201, and portions of the plurality of second word lines 203 are arranged in spaces formed by the plurality of first word lines 201. The fact that portions of the plurality of second word lines 203 are arranged in spaces formed by the plurality of first word lines 201 may improve the tightness of the connection between the plurality of second word lines 203 and the plurality of first word lines 201.

In some embodiments, the plurality of capacitors 260 may include a plurality of lower electrode plates 261, a plurality of capacitive dielectric layers 262 and a plurality of upper electrode plates 263. Each of the plurality of lower electrode plates 261 covers a part of a surface of a respective one of the plurality of initial active layers 140. Each of the plurality of capacitive dielectric layers 262 covers a surface of a respective one of the plurality of lower electrode plates 261, and each of the plurality of capacitive dielectric layers 262 also covers another part of the surface of a respective one of the plurality of initial active layers 140 away from a respective one of the plurality of lower electrode plates 261. The plurality of upper electrode plates 263 cover surfaces of the plurality of capacitive dielectric layers 262. A relative area of each of the plurality of lower electrode plates 261 and a respective one of the plurality of upper electrode plates 263 of the plurality of capacitors 260, a distance between each of the plurality of lower electrode plates 261 and a respective one of the plurality of upper electrode plates 263, and the material of the plurality of capacitive dielectric layers 262 may affect the capacity of the plurality of capacitors 260. Therefore, the relative area of each of the plurality of lower electrode plates 261 and a respective one of the plurality of upper electrode plates 263 of the plurality of capacitors 260, the distance between each of the plurality of lower electrode plates 261 and the respective one of the plurality of upper electrode plates 263, and the material of the plurality of capacitive dielectric layers 262 may be provided according to the actual requirements.

In some embodiments, multiple capacitors 260 of the plurality of capacitors 260 arranged along the first direction share one upper electrode plate 263. The formation of the multiple capacitors 260 of the plurality of capacitors 260 sharing one upper electrode plate 263 may improve the utilization rate of the space of the semiconductor structure and may facilitate the formation of the semiconductor structure.

In some embodiments, a thickness of each of the plurality of active structures 180 in the first direction X ranges from 15 nm to 25 nm, such as 18 nm, 20 nm and 22 nm, etc. The fact that the thickness of each of the plurality of active structures 180 ranges from 15 nm to 25 nm may improve the electrical properties of the semiconductor structure.

In some embodiments, a doping concentration of each of the plurality of initial active layers 140 ranges from 1E19 cm⁻³ to 1E22 cm⁻³, such as 1E20 cm⁻³ and 1E21 cm⁻³, etc. It can be understood that the remaining portion of each of the plurality of initial active layers 140 may serve as a source or a drain of the semiconductor structure, and the doping concentration of each of the plurality of initial active layers 140 corresponds to the number of carriers of the source or the drain of the semiconductor structure. The fact that the doping concentration of each of the plurality of initial active layers 140 ranges from 1E19 cm⁻³ to 1E22 cm⁻³ may improve the number of the carriers of the source or the drain, to improve the performance of the semiconductor structure.

In some embodiments, the semiconductor structure further includes a plurality of second isolation layers 190, and the plurality of second isolation layers 190 are arranged between the plurality of active structures 180 spaced apart from each other along the second direction Y. Every two adjacent active structures 180 of the plurality of active structures 180 arranged along the second direction Y may be isolated by a respective one of the plurality of second isolation layers 190, which may prevent the mutual influence of the plurality of active structures 180 arranged along the second direction Y.

In some embodiments, top surfaces of the plurality of conductive pillars 290 may be flush with each other, that is, the lengths of the plurality of conductive pillars 290 are different. The lengths of the plurality of word lines 200 in the first direction X sequentially decrease , and the lengths of the plurality of conductive pillars 290 in the first direction X increase. That is, conductive pillars 290 connected with word lines 200 arranged on a bottom surface of the semiconductor structure have highest lengths. The fact that the plurality of conductive pillars 290 are flush with a top surface of the semiconductor structure may allow an electrical signal to be supplied to the plurality of word lines 200 through the top surface of the semiconductor structure, to control the reading out data and the writing data of the semiconductor structure.

An embodiment of the application provides a semiconductor structure, which includes a base 100, a plurality of active structures 180 arranged on a surface of the base 100, and a plurality of first isolation layers 120. The plurality of active structures 180 include a plurality of oxide semiconductor layers 170 and a plurality of initial active layers 140, and each of the plurality of oxide semiconductor layers 170 is in contact with a respective one of the plurality of initial active layers 140. The plurality of first isolation layers 120 are arranged between the plurality of active structures 180 adjacent to each other in the first direction X. The fact that the plurality of active structures 180 include the plurality of oxide semiconductor layers 170 and the plurality of initial active layers 140, and the plurality of oxide semiconductor layers 170 are formed may improve the mobility of carriers of the plurality of active structures 180, and may improve the performance of the semiconductor structure.

Those skilled in the art will appreciate that the above various implementations are the specific embodiments for implementing the application. In the practical application, various changes may be made to the above various implementations in terms of form and detail without departing from the spirit and scope of the embodiments of the application. Therefore, the scope of protection of the embodiments of the application shall be subject to the scope of protection of the claims.

## Claims

1. A method for manufacturing a semiconductor structure, **characterized in that** the method comprises:
providing a base (100);
forming a plurality of stack structures (110) on a surface of the base (100) and forming a plurality of first isolation layers (120), wherein the plurality of stack structures (110) and the plurality of first isolation layers (120) arranged alternatingly along a first direction (X), wherein the plurality of stack structures (110) comprises a plurality of first interlayer dielectric layers (130), a plurality of second interlayer dielectric layers (150), and a plurality of initial active layers (140) being between the plurality of first interlayer dielectric layers (130) and the plurality of second interlayer dielectric layers (150);
etching portion of each initial active layer (140) to form a first trench (160) in each of the plurality of stack structures (110);
forming a plurality of oxide semiconductor layers (170) in a plurality of first trenches (160), wherein each of the plurality of oxide semiconductor layers (170) is in contact with a remaining portion of a respective one of the plurality of initial active layers (140); and
etching portions of the plurality of oxide semiconductor layers (170) and remaining portions of the plurality of initial active layers (140) to form a plurality of active structures (180) arranged in an array along the first direction (X) and a second direction (Y),
wherein the first direction (X) is perpendicular to the surface of the base (100), the second direction (Y) is parallel to the surface of the base (100).

2. The method for manufacturing the semiconductor structure according to claim 1, wherein after the plurality of active structures (180) are formed, the method further comprising:
forming a plurality of word lines (200), wherein each of the plurality of word lines (200) surrounds a part of a surface of a respective one of the plurality of oxide semiconductor layers (170), and each of the plurality of word lines (200) extends along one of the first direction (X) and the second direction (Y); and
forming a plurality of bit lines (230), wherein each of the plurality of bit lines (230) surrounds a part of a surface of a respective one of the plurality of oxide semiconductor layers (170), each of the plurality of bit lines (230) is spaced from a respective one of the plurality of word lines (200), and each of the plurality of bit lines (230) extends along another one of the first direction (X) and the second direction (Y);
wherein each of the plurality of word lines (200) extends along the second direction (Y), and wherein forming the plurality of word lines (200) comprises:
forming a plurality of first word lines (201), wherein each of the plurality of first word lines (201) surrounds a respective one of the plurality of oxide semiconductor layers (170); and
forming a plurality of second word lines (203), wherein each of the plurality of second word lines (203) covers a side wall of a respective one of the plurality of first word lines (201).

3. The method for manufacturing the semiconductor structure according to claim 2, wherein forming the plurality of first word lines (201) comprises:
etching the plurality of first interlayer dielectric layers (130) and the plurality of second interlayer dielectric layers (150) of the plurality of stack structures (110) to form a plurality of first grooves (220), wherein each first groove (220) exposes a surface of a respective one of the plurality of oxide semiconductor layers (170);
forming a plurality of gate dielectric layers (210) on surfaces of the plurality of first grooves (220); and
forming the plurality of first word lines (201) on surfaces of the plurality of gate dielectric layers (210), wherein the plurality of first grooves (220) are fully filled with the plurality of gate dielectric layers (210) and the plurality of first word lines (201).

4. The method for manufacturing the semiconductor structure according to claim 2, wherein forming the plurality of second word lines (203) comprises:
etching the plurality of stack structures (110) along the second direction (Y) to form a plurality of second grooves (221), wherein each second groove (221) exposes a side wall of a respective one of the plurality of first word lines (201);
forming a plurality of second initial word lines (204), wherein the plurality of second grooves (221) are fully filled with the plurality of second initial word lines (204); and
etching the plurality of second initial word lines (204) to form the plurality of second word lines (203), wherein the plurality of second word lines (203) are arranged along the first direction (X) and lengths of the plurality of second word lines (203) in the second direction (Y) sequentially decrease.

5. The method for manufacturing the semiconductor structure according to any one of claims 2 to 4, wherein forming the plurality of bit lines (230) comprises:
forming a plurality of third isolation layers (240), wherein each of the plurality of third isolation layers (240) covers a part of a surface of a respective one of the plurality of oxide semiconductor layers (170), and each of the plurality of third isolation layers (240) is in contact with a side wall arranged along the third direction (Z) of a respective one of the plurality of word lines (200); and
forming the plurality of bit lines (230), wherein each of the plurality of bit lines (230) is in contact with a side wall arranged along the third direction (Z) of a respective one of the plurality of third isolation layers (240), and each of the plurality of bit lines (230) covers a respective one of the plurality of oxide semiconductor layers (170).

6. The method for manufacturing the semiconductor structure according to any one of claims 1 to 5, wherein a material of the plurality of oxide semiconductor layers (170) comprises indium gallium zinc oxide or zinc tin oxide.

7. The method for manufacturing the semiconductor structure according to any one of claims 1 to 6, wherein etching portions of the plurality of oxide semiconductor layers (170) comprises:
etching the plurality of stack structures (110) to form the plurality of active structures (180) spaced apart from each other along the second direction (Y); and
forming a plurality of second isolation layers (190), wherein the plurality of second isolation layers (190) are arranged between the plurality of active structures (180) spaced apart from each other along the second direction (Y).

8. The method for manufacturing the semiconductor structure according to any one of claims 1 to 7, further comprising:
etching the plurality of first interlayer dielectric layers (130), the plurality of first isolation layers (120) and the plurality of second interlayer dielectric layers (150) to form a plurality of third grooves (250), wherein each of the plurality of third grooves (250) exposes a part of a surface of the remaining portion of the respective one of the plurality of initial active layers (140);
forming a plurality of lower electrode plates (261), wherein each of the plurality of lower electrode plates (261) covers a part of the surface of the remaining portion of the respective one of the plurality of initial active layers (140);
forming a plurality of capacitive dielectric layers (262), wherein each of the plurality of capacitive dielectric layers (262) covers a surface of a respective one of the plurality of lower electrode plates (261) and a part of the surface of the remaining portion of the respective one of the plurality of initial active layers (140); and
forming a plurality of upper electrode plates (263), wherein the plurality of upper electrode plates (263) cover surfaces of the plurality of capacitive dielectric layers (262), wherein the plurality of lower electrode plates (261), the plurality of capacitive dielectric layers (262) and the plurality of upper electrode plates (263) form a plurality of capacitors (260);
wherein forming the plurality of lower electrode plates (261) comprises:
forming a plurality of fourth isolation layers (270), wherein each of the plurality of fourth isolation layers (270) covers a surface of a side wall arranged along the third direction (Z) of a respective one of the plurality of third grooves (250);
forming a plurality of initial lower electrode plates (261), wherein each of the plurality of initial lower electrode plates (261) covers a surface of a respective one of the plurality of fourth isolation layers (270) and the surface of the remaining portion of the respective one of the plurality of initial active layers (140); and
removing each of the plurality of fourth isolation layers (270) and a portion of each of the plurality of initial lower electrode plates (261) that covers the surface of the respective one of the plurality of fourth isolation layers (270), wherein remaining portions of the plurality of initial lower electrode plates (261) serve as the plurality of lower electrode plates (261).

## Patentansprüche

1. Verfahren zum Herstellen einer Halbleiterstruktur, **dadurch gekennzeichnet, dass** das Verfahren Folgendes umfasst:
Bereitstellen einer Basis (100);
Bilden einer Vielzahl von Stapelstrukturen (110) auf einer Oberfläche der Basis (100) und Bilden einer Vielzahl von ersten Isolationsschichten (120), wobei die Vielzahl von Stapelstrukturen (110) und die Vielzahl von ersten Isolationsschichten (120) abwechselnd entlang einer ersten Richtung (X) angeordnet sind, wobei die Vielzahl von Stapelstrukturen (110) eine Vielzahl von ersten dielektrischen Zwischenschichten (130), eine Vielzahl von zweiten dielektrischen Zwischenschichten (150) und eine Vielzahl von anfänglichen aktiven Schichten (140) umfasst, die zwischen der Vielzahl von ersten dielektrischen Zwischenschichten (130) und der Vielzahl von zweiten dielektrischen Zwischenschichten (150) sind;
Ätzen eines Abschnitts von jeder anfänglichen aktiven Schicht (140), um einen ersten Graben (160) in jeder der Vielzahl von Stapelstrukturen (110) zu bilden;
Bilden einer Vielzahl von Oxid-Halbleiterschichten (170) in einer Vielzahl von ersten Gräben (160), wobei jede der Vielzahl von Oxid-Halbleiterschichten (170) in Kontakt mit einem verbleibenden Abschnitt einer jeweiligen der Vielzahl von anfänglichen aktiven Schichten (140) ist; und
Ätzen von Abschnitten der Vielzahl von Oxid-Halbleiterschichten (170) und verbleibenden Abschnitten der Vielzahl von anfänglichen aktiven Schichten (140), um eine Vielzahl von aktiven Strukturen (180) zu bilden, die in einem Muster entlang der ersten Richtung (X) und einer zweiten Richtung (Y) angeordnet sind,
wobei die erste Richtung (X) senkrecht zu der Oberfläche der Basis (100) ist, die zweite Richtung (Y) parallel zu der Oberfläche der Basis (100) ist.

2. Verfahren zum Herstellen der Halbleiterstruktur nach Anspruch 1, wobei das Verfahren nach Bilden der Vielzahl von aktiven Strukturen (180) ferner Folgendes umfasst:
Bilden einer Vielzahl von Wortlinien (200), wobei jede der Vielzahl von Wortlinien (200) einen Teil einer Oberfläche einer jeweiligen der Vielzahl von Oxid-Halbleiterschichten (170) umgibt und sich jede der Vielzahl von Wortlinien (200) entlang einer der ersten Richtung (X) und der zweiten Richtung (Y) erstreckt; und
Bilden einer Vielzahl von Bitlinien (230), wobei jede der Vielzahl von Bitlinien (230) einen Teil einer Oberfläche einer jeweiligen der Vielzahl von Oxid-Halbleiterschichten (170) umgibt, jede der Vielzahl von Bitlinien (230) von einer jeweiligen der Vielzahl von Wortlinien (200) beabstandet ist, und jede der Vielzahl von Bitlinien (230) sich entlang einer anderen von der ersten Richtung (X) und der zweiten Richtung (Y) erstreckt;
wobei sich jede der Vielzahl von Wortlinien (200) entlang der zweiten Richtung (Y) erstreckt, und wobei ein Bilden der Vielzahl von Wortlinien (200) Folgendes umfasst:
Bilden einer Vielzahl von ersten Wortlinien (201), wobei jede der Vielzahl von ersten Wortlinien (201) eine entsprechende der Vielzahl von Oxid-Halbleiterschichten (170) umgibt; und
Bilden einer Vielzahl von zweiten Wortlinien (203), wobei jede der Vielzahl von zweiten Wortlinien (203) eine Seitenwand einer entsprechenden der Vielzahl von ersten Wortlinien (201) abdeckt.

3. Verfahren zum Herstellen der Halbleiterstruktur nach Anspruch 2, wobei ein Bilden der Vielzahl von ersten Wortlinien (201) Folgendes umfasst:
Ätzen der Vielzahl von ersten dielektrischen Zwischenschichten (130) und der Vielzahl von zweiten dielektrischen Zwischenschichten (150) der Vielzahl von Stapelstrukturen (110), um eine Vielzahl von ersten Rillen (220) zu bilden, wobei jede erste Rille (220) eine Oberfläche einer jeweiligen der Vielzahl von Oxid-Halbleiterschichten (170) freilegt;
Bilden einer Vielzahl von dielektrischen Gate-Schichten (210) auf Oberflächen der Vielzahl von ersten Rillen (220); und
Bilden der Vielzahl von ersten Wortlinien (201) auf Oberflächen der Vielzahl von dielektrischen Gate-Schichten (210), wobei die Vielzahl von ersten Rillen (220) vollständig mit der Vielzahl von dielektrischen Gate-Schichten (210) und der Vielzahl von ersten Wortlinien (201) gefüllt ist.

4. Verfahren zum Herstellen der Halbleiterstruktur nach Anspruch 2, wobei ein Bilden der Vielzahl von zweiten Wortlinien (203) Folgendes umfasst:
Ätzen der Vielzahl von Stapelstrukturen (110) entlang der zweiten Richtung (Y), um eine Vielzahl von zweiten Rillen (221) zu bilden, wobei jede zweite Rille (221) eine Seitenwand einer jeweiligen der Vielzahl von ersten Wortlinien (201) freilegt;
Bilden einer Vielzahl von zweiten anfänglichen Wortlinien (204), wobei die Vielzahl von zweiten Rillen (221) vollständig mit der Vielzahl von zweiten anfänglichen Wortlinien (204) gefüllt ist; und
Ätzen der Vielzahl von zweiten anfänglichen Wortlinien (204), um die Vielzahl von zweiten Wortlinien (203) zu bilden, wobei die Vielzahl von zweiten Wortlinien (203) entlang der ersten Richtung (X) angeordnet sind und Längen der Vielzahl von zweiten Wortlinien (203) in der zweiten Richtung (Y) sequentiell abnehmen.

5. Verfahren zum Herstellen der Halbleiterstruktur nach einem der Ansprüche 2 bis 4, wobei ein Bilden der Vielzahl von Bitlinien (230) Folgendes umfasst:
Bilden einer Vielzahl von dritten Isolationsschichten (240), wobei jede der Vielzahl von dritten Isolationsschichten (240) einen Teil einer Oberfläche einer jeweiligen der Vielzahl von Oxid-Halbleiterschichten (170) bedeckt und jede der Vielzahl von dritten Isolationsschichten (240) in Kontakt mit einer Seitenwand ist, die entlang der dritten Richtung (Z) einer jeweiligen der Vielzahl von Wortlinien (200) angeordnet ist; und
Bilden der Vielzahl von Bitlinien (230), wobei jede der Vielzahl von Bitlinien (230) in Kontakt mit einer Seitenwand ist, die entlang der dritten Richtung (Z) einer jeweiligen der Vielzahl von dritten Isolationsschichten (240) angeordnet ist, und jede der Vielzahl von Bitlinien (230) eine jeweilige der Vielzahl von Oxid-Halbleiterschichten (170) bedeckt.

6. Verfahren zum Herstellen der Halbleiterstruktur nach einem der Ansprüche 1 bis 5, wobei ein Material der Vielzahl von Oxid-Halbleiterschichten (170) Indium-Gallium-Zink-Oxid oder Zink-Zinn-Oxid umfasst.

7. Verfahren zum Herstellen der Halbleiterstruktur nach einem der Ansprüche 1 bis 6, wobei ein Ätzen von Abschnitten der Vielzahl von Oxid-Halbleiterschichten (170) Folgendes umfasst:
Ätzen der Vielzahl von Stapelstrukturen (110), um die Vielzahl von aktiven Strukturen (180) zu bilden, die entlang der zweiten Richtung (Y) voneinander beabstandet sind; und
Bilden einer Vielzahl von zweiten Isolationsschichten (190), wobei die Vielzahl von zweiten Isolationsschichten (190) zwischen der Vielzahl von aktiven Strukturen (180) angeordnet ist, die entlang der zweiten Richtung (Y) voneinander beabstandet sind.

8. Verfahren zum Herstellen der Halbleiterstruktur nach einem der Ansprüche 1 bis 7, ferner umfassend:
Ätzen der Vielzahl von ersten dielektrischen Zwischenschichten (130), der Vielzahl von ersten Isolationsschichten (120) und der Vielzahl von zweiten dielektrischen Zwischenschichten (150), um eine Vielzahl von dritten Rillen (250) zu bilden, wobei jede der Vielzahl von dritten Rillen (250) einen Teil einer Oberfläche des verbleibenden Abschnitts der jeweiligen der Vielzahl von anfänglichen aktiven Schichten (140) freilegt;
Bilden einer Vielzahl von unteren Elektrodenplatten (261), wobei jede der Vielzahl von unteren Elektrodenplatten (261) einen Teil der Oberfläche des verbleibenden Abschnitts der jeweiligen der Vielzahl von anfänglichen aktiven Schichten (140) bedeckt;
Bilden einer Vielzahl von kapazitiven dielektrischen Schichten (262), wobei jede der Vielzahl von kapazitiven dielektrischen Schichten (262) eine Oberfläche einer jeweiligen der Vielzahl von unteren Elektrodenplatten (261) und einen Teil der Oberfläche des verbleibenden Abschnitts der jeweiligen der Vielzahl von anfänglichen aktiven Schichten (140) bedeckt; und
Bilden einer Vielzahl von oberen Elektrodenplatten (263), wobei die Vielzahl von oberen Elektrodenplatten (263) Oberflächen der Vielzahl von kapazitiven dielektrischen Schichten (262) bedeckt, wobei die Vielzahl von unteren Elektrodenplatten (261), die Vielzahl von kapazitiven dielektrischen Schichten (262) und die Vielzahl von oberen Elektrodenplatten (263) eine Vielzahl von Kondensatoren (260) bilden;
wobei ein Bilden der Vielzahl von unteren Elektrodenplatten (261) Folgendes umfasst:
Bilden einer Vielzahl von vierten Isolationsschichten (270), wobei jede der Vielzahl von vierten Isolationsschichten (270) eine Oberfläche einer Seitenwand bedeckt, die entlang der dritten Richtung (Z) einer jeweiligen der Vielzahl von dritten Rillen (250) angeordnet ist;
Bilden einer Vielzahl von anfänglichen unteren Elektrodenplatten (261), wobei jede der Vielzahl von anfänglichen unteren Elektrodenplatten (261) eine Oberfläche einer jeweiligen der Vielzahl von vierten Isolationsschichten (270) und die Oberfläche des verbleibenden Abschnitts der jeweiligen der Vielzahl von anfänglichen aktiven Schichten (140) bedeckt; und
Entfernen jeder der Vielzahl von vierten Isolationsschichten (270) und eines Abschnitts jeder der Vielzahl von unteren Anfangselektrodenplatten (261), der die Oberfläche der jeweiligen der Vielzahl von vierten Isolationsschichten (270) bedeckt, wobei verbleibende Abschnitte der Vielzahl von unteren Anfangselektrodenplatten (261) als die Vielzahl von unteren Elektrodenplatten (261) dienen.

## Revendications

1. Procédé de fabrication d'une structure semi-conductrice, **caractérisé en ce que** le procédé comprend :
la fourniture d'une base (100) ;
la formation d'une pluralité de structures d'empilement (110) sur une surface de la base (100) et la formation d'une pluralité de premières couches d'isolation (120), dans lequel la pluralité de structures d'empilement (110) et la pluralité de premières couches d'isolation (120) sont disposées alternativement le long d'une première direction (X), dans lequel la pluralité de structures d'empilement (110) comprend une pluralité de premières couches diélectriques intercalaires (130), une pluralité de secondes couches diélectriques intercalaires (150), et une pluralité de couches actives initiales (140) situées entre la pluralité de premières couches diélectriques intercalaires (130) et la pluralité de secondes couches diélectriques intercalaires (150) ;
la gravure d'une partie de chaque couche active initiale (140) pour former une première tranchée (160) dans chacune de la pluralité de structures d'empilement (110) ;
la formation d'une pluralité de couches semi-conductrices d'oxyde (170) dans une pluralité de premières tranchées (160), dans lequel chacune de la pluralité de couches semi-conductrices d'oxyde (170) est en contact avec une partie restante de l'une respective de la pluralité de couches actives initiales (140) ; et
la gravure de parties de la pluralité de couches semi-conductrices d'oxyde (170) et de parties restantes de la pluralité de couches actives initiales (140) pour former une pluralité de structures actives (180) disposées en réseau le long de la première direction (X) et de la deuxième direction (Y),
dans lequel la première direction (X) est perpendiculaire à la surface de la base (100), la deuxième direction (Y) est parallèle à la surface de la base (100).

2. Procédé de fabrication de la structure semi-conductrice selon la revendication 1, dans lequel, après la formation de la pluralité de structures actives (180), le procédé comprend en outre :
la formation d'une pluralité de lignes de mots (200), dans lequel chacune de la pluralité de lignes de mots (200) entoure une partie d'une surface d'une couche respective de la pluralité de couches semi-conductrices d'oxyde (170), et chacune de la pluralité de lignes de mots (200) s'étend le long de l'une de la première direction (X) et de la deuxième direction (Y) ; et
la formation d'une pluralité de lignes de bits (230), dans lequel chacune de la pluralité de lignes de bits (230) entoure une partie d'une surface d'une couche respective de la pluralité de couches semi-conductrices d'oxyde (170), chacune de la pluralité de lignes de bits (230) est espacée d'une ligne respective de la pluralité de lignes de mots (200), et chacune de la pluralité de lignes de bits (230) s'étend le long d'une autre de la première direction (X) et de la deuxième direction (Y) ;
dans lequel chacune de la pluralité de lignes de mots (200) s'étend le long de la deuxième direction (Y), et dans lequel la formation de la pluralité de lignes de mots (200) comprend :
la formation d'une pluralité de premières lignes de mots (201), dans lequel chacune de la pluralité de premières lignes de mots (201) entoure une couche respective de la pluralité de couches semi-conductrices d'oxyde (170) ; et
la formation d'une pluralité de secondes lignes de mots (203), dans lequel chaque ligne de la pluralité de secondes lignes de mots (203) recouvre une paroi latérale d'une ligne respective de la pluralité de premières lignes de mots (201).

3. Procédé de fabrication de la structure semi-conductrice selon la revendication 2, dans lequel la formation de la pluralité de premières lignes de mots (201) comprend :
la gravure de la pluralité de premières couches diélectriques intercalaires (130) et de la pluralité de secondes couches diélectriques intercalaires (150) de la pluralité de structures d'empilement (110) pour former une pluralité de premières rainures (220), dans lequel chaque première rainure (220) expose une surface d'une couche respective de la pluralité de couches semi-conductrices d'oxyde (170) ;
la formation d'une pluralité de couches diélectriques de grille (210) sur les surfaces de la pluralité de premières rainures (220) ; et
la formation de la pluralité de premières lignes de mots (201) sur les surfaces de la pluralité de couches diélectriques de grille (210), dans lequel la pluralité de premières rainures (220) est entièrement remplie par la pluralité de couches diélectriques de grille (210) et la pluralité de premières lignes de mots (201).

4. Procédé de fabrication de la structure semi-conductrice selon la revendication 2, dans lequel la formation de la pluralité de secondes lignes de mots (203) comprend :
la gravure de la pluralité de structures d'empilement (110) le long de la deuxième direction (Y) pour former une pluralité de deuxièmes rainures (221), dans lequel chaque deuxième rainure (221) expose une paroi latérale d'une ligne respective de la pluralité de premières lignes de mots (201) ;
la formation d'une pluralité de secondes lignes de mots initiales (204), dans lequel la pluralité de deuxièmes rainures (221) est entièrement remplie par la pluralité de secondes lignes de mots initiales (204) ; et
la gravure de la pluralité de secondes lignes de mots initiales (204) pour former la pluralité de secondes lignes de mots (203), dans lequel la pluralité de secondes lignes de mots (203) est disposée le long de la première direction (X) et les longueurs de la pluralité de secondes lignes de mots (203) dans la deuxième direction (Y) diminuant successivement.

5. Procédé de fabrication de la structure semi-conductrice selon l'une quelconque des revendications 2 à 4, dans lequel la formation de la pluralité de lignes de bits (230) comprend :
la formation d'une pluralité de troisièmes couches d'isolation (240), dans lequel chaque couche de la pluralité de troisièmes couches d'isolation (240) couvre une partie d'une surface d'une couche respective de la pluralité de couches semi-conductrices d'oxyde (170), et chaque couche de la pluralité de troisièmes couches d'isolation (240) est en contact avec une paroi latérale disposée le long de la troisième direction (Z) d'une ligne respective de la pluralité de lignes de mots (200) ; et
la formation de la pluralité de lignes de bits (230), dans lequel chaque ligne de la pluralité de lignes de bits (230) est en contact avec une paroi latérale disposée le long de la troisième direction (Z) d'une couche respective de la pluralité de troisièmes couches d'isolation (240), et chaque ligne de la pluralité de lignes de bits (230) couvre une couche respective de la pluralité de couches semi-conductrices d'oxyde (170).

6. Procédé de fabrication de la structure semi-conductrice selon l'une quelconque des revendications 1 à 5, dans lequel un matériau de la pluralité de couches semi-conductrices d'oxyde (170) comprend de l'oxyde de zinc, de gallium et d'indium ou de l'oxyde d'étain et de zinc.

7. Procédé de fabrication de la structure semi-conductrice selon l'une quelconque des revendications 1 à 6, dans lequel la gravure de parties de la pluralité de couches semi-conductrices d'oxyde (170) comprend :
la gravure de la pluralité de structures d'empilement (110) pour former la pluralité de structures actives (180) espacées les unes des autres le long de la deuxième direction (Y) ; et
la formation d'une pluralité de deuxièmes couches d'isolation (190), dans lequel la pluralité de deuxièmes couches d'isolation (190) est disposée entre la pluralité de structures actives (180) espacées les unes des autres le long de la deuxième direction (Y).

8. Procédé de fabrication de la structure semi-conductrice selon l'une quelconque des revendications 1 à 7, comprenant en outre :
la gravure de la pluralité de premières couches diélectriques intercalaires (130), de la pluralité de premières couches d'isolation (120) et de la pluralité de secondes couches diélectriques intercalaires (150) pour former une pluralité de troisièmes rainures (250), dans lequel chaque rainure de la pluralité de troisièmes rainures (250) expose une partie d'une surface de la partie restante d'une couche respective de la pluralité de couches actives initiales (140) ;
la formation d'une pluralité de plaques d'électrode inférieures (261), dans lequel chaque plaque de la pluralité de plaques d'électrode inférieures (261) couvre une partie de la surface de la partie restante de la couche respective de la pluralité de couches actives initiales (140) ;
la formation d'une pluralité de couches diélectriques capacitives (262), dans lequel chaque couche de la pluralité de couches diélectriques capacitives (262) couvre une surface d'une plaque respective de la pluralité de plaques d'électrode inférieures (261) et une partie de la surface de la portion restante de la couche respective de la pluralité de couches actives initiales (140) ; et
la formation d'une pluralité de plaques d'électrode supérieures (263), dans lequel la pluralité de plaques d'électrode supérieures (263) couvre les surfaces de la pluralité de couches diélectriques capacitives (262), dans lequel la pluralité de plaques d'électrode inférieures (261), la pluralité de couches diélectriques capacitives (262) et la pluralité de plaques d'électrode supérieures (263) forment une pluralité de condensateurs (260) ;
dans lequel la formation de la pluralité de plaques d'électrode inférieures (261) comprend :
la formation d'une pluralité de quatrièmes couches d'isolation (270), dans lequel chaque couche de la pluralité de quatrièmes couches d'isolation (270) couvre une surface d'une paroi latérale disposée le long de la troisième direction (Z) d'une rainure respective de la pluralité de troisièmes rainures (250) ;
la formation d'une pluralité de plaques d'électrode inférieures initiales (261), dans lequel chaque plaque de la pluralité de plaques d'électrode inférieures initiales (261) couvre une surface d'une couche respective de la pluralité de quatrièmes couches d'isolation (270) et la surface de la partie restante de la couche respective de la pluralité de couches actives initiales (140) ; et
l'élimination de chaque couche de la pluralité de quatrièmes couches d'isolation (270) et d'une partie de chaque plaque de la pluralité de plaques d'électrode inférieures (261) initiales qui couvre la surface de la couche respective de la pluralité de quatrièmes couches d'isolation (270), dans lequel les parties restantes de la pluralité de plaques d'électrode inférieures initiales (261) servent de pluralité de plaques d'électrode inférieures (261).
